# EUROPEAN PATENT SPECIFICATION

(11) **EP 2 034 002 B1**
(45) Date of publication and mention of the grant of the patent: **17.07.2013**
(21) Application number: 08163169.9
(22) Date of filing: 28.08.2008
(51) Int. Cl.: C09K 11/88, C09K 11/56, C09K 11/59, C30B 7/00, C30B 29/46, C30B 29/48, C30B 29/50, C30B 5/00, C30B 29/54, C30B 7/14, C30B 29/60, B82Y 30/00, B82Y 40/00

(54) **Nanoncrystal-metal oxide composites and preparation method thereof**
Nanokristall-Metalloxid-Verbundstoffe und Herstellungsverfahren dafür
Composites d'oxyde métallique à nanocristaux et leur procédé de fabrication

(30) Priority: 04.09.2007 KR 20070089535; 09.11.2007 KR 20070114329; 07.08.2008 KR 20080077613
(43) Date of publication of application: 11.03.2009
(73) Proprietor: Samsung Electronics Co., Ltd., Suwon-si, Gyeonggi-do, 443-742 (KR)
(72) Inventor: Jun, Shin Ae c/o Samsung Advanced Institute of Technology , Mt., 449-712, Gyeonggi-do (KR); Jang, Eun Joo c/o Samsung Advanced Institute of Technology , Mt., 449-712, Gyeonggi-do (KR)
(74) Representative: Zijlstra, Robert Wiebo Johan

(56) References cited:
- WO-A1-2004/054923
- WO-A1-2007/130190
- WO-A2-2005/067524
- US-A- 5 990 479
- US-A1- 2002 072 234

## Description

This disclosure is directed to nanocrystal-metal oxide composites and a method for preparing the composites. More specifically, the nanocrystal-metal oxide composites comprise nanocrystals and a metal oxide bound to the nanocrystals wherein the metal oxide has organic groups.

In general, the luminescence and electrical properties of nanocrystals can be controlled by varying various factors (*e.g.,* size and composition) of the nanocrystals. Such characteristics make nanocrystals excellent candidates for application in light-emitting devices, solar cells, sensors, memory devices, and the like.

Nanocrystals may be dispersed in a transparent metal oxide matrix to prepare composites. Use of nanocrystal composites can prevent the constituent nanocrystals from being oxidized or from aggregating due to external stimuli, thereby enhancing the stability of the nanocrystals.

The surface of a nanocrystal prepared by a wet process is covered by an organic dispersant. Before a mixture of such nanocrystals and a metal oxide matrix precursor can undergo a sol-gel reaction to prepare nanocrystal-metal oxide composites, the organic dispersant is replaced with a surfactant having reactivity toward the metal oxide precursor.

The addition of a catalyst and water to the mixture induces crosslinking between the nanocrystals and the metal oxide precursor to form alcohol, water, halogen, or the like, which can cause considerable shrinkage in the volume of the resulting composites.

This volume shrinkage acts to apply mechanical stress to the composites, which can leave defects such as cracks and pores within the composites. Such defects become factors that can cause deterioration of the stability and processability of the composites.

Accordingly, disclosed herein are nanocrystal-metal oxide composites comprising nanocrystals and a metal oxide bound to the nanocrystals wherein the metal oxide has organic groups.

Also disclosed is a method for preparing nanocrystal-metal oxide composites, comprising modifying surfaces of nanocrystals with a surfactant and mixing the surface-modified nanocrystals with a metal oxide precursor having organic groups, a solvent, and water to form a sol-gel, wherein the surfactant is reactive with the metal oxide precursor.

Exemplary embodiments will be more clearly understood from the following detailed description taken in conjunction with the accompanying drawings, wherein:
FIG. 1 shows absorption and luminescence spectra of exemplary nanocrystals prepared in Preparative Example 1;
FIG. 2 is a photograph showing the shape of exemplary composites prepared in Example 1 after curing;
FIG. 3 is a photograph showing the shape of exemplary composites prepared in Comparative Example 1 after curing;
FIG. 4a is a photograph showing the variation in the volume of exemplary composites prepared in Example 2 after curing, and FIG. 4b is a photograph showing the variation in the volume of exemplary composites prepared in Comparative Example 1 after curing;
FIG. 5 is an optical microscopy image of exemplary composites prepared in Example 2 after curing; and
FIG. 6 is an optical microscopy image of exemplary composites prepared in Comparative Example 1 after curing.

Hereinafter, a detailed description will be given of example embodiments with reference to the accompanying drawings.

It will be understood that when an element or layer is referred to as being "on," "interposed," "disposed," or "between" another element or layer, it can be directly on, interposed, disposed, or between the other element or layer or intervening elements or layers may be present.

It will be understood that, although the terms first, second, third, and the like may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, first element, component, region, layer or section may be termed as a second element, component, region, layer or section without departing from the teachings of the present invention.

As used herein, the singular forms "a," "an" and "the" are intended to comprise the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

According to one embodiment, there are provided nanocrystal-metal oxide composites comprising nanocrystals and a metal oxide bound to the nanocrystals wherein the metal oxide has organic groups.

The metal oxide is a compound represented by Formula 1: 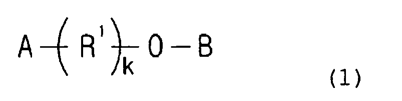 wherein A is N, NH, S, COO⁻, PO₃H⁻ or PO₃²⁻,
R¹ is an alkylene group containing at least one carbon atom, an alkenyl group containing at least two carbon atoms, or a cyclic group containing at least three carbon atoms,
B is one or more repeating units selected from the group consisting of 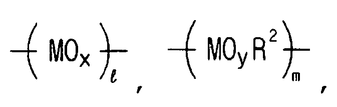 and 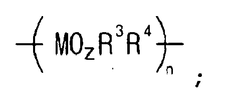 wherein each M is Ti, Zn, Si, Sn, W, Ta, Zr, Hf, Al, Y, Fe, Ce or Cr,
R², R³ and R⁴ are each independently an alkyl group containing at least one carbon atom, an alkenyl group containing at least two carbon atoms, or a heterocyclic group containing at least three carbon atoms and at least one heteroatom selected from the group consisting of N, S, O and P,
k is an integer from 1 to 20,
l, m, and n are each independently an integer including 0 and at least one of l, m, or n is greater than 0, and
x, y, and z are each independently an integer from 1 to 3. It will be understood that where A is N, NH, and S, the unspecified valencies other than that bound to R¹ are bound to the surface of the nanocrystal.

In Formula 1, the repeating units B may be arranged in any order. The metal elements of the repeating units B may be identical to or different from each other. That is, two or more repeating units containing the same or different metal elements may be arranged in any order in the compound of Formula 1. x, y and z corresponding to the numbers of the oxygen atoms capable of bonding to the respective metal elements may vary depending on the kind of the metal elements.

The surfactant of the exemplary embodiments may be one of compounds represented by Formulas 2 to 4 below: 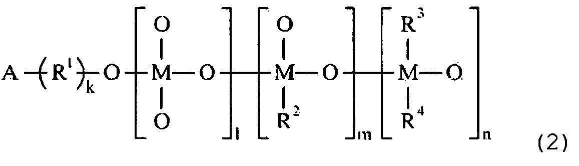 wherein A is N, NH, S, COO⁻, PO₃H⁻ or PO₃²⁻,
R¹ is an alkylene group containing at least one carbon atom, an alkenyl group containing at least two carbon atoms, or a cyclic group containing at least three carbon atoms,
M is Ti, Zn, Si, Sn, W, Ta, Zr, Hf, Al, Y, Fe, Ce or Cr,
R², R³ and R⁴ are each independently an alkyl group containing at least one carbon atom, an alkenyl group containing at least two carbon atoms, or a heterocyclic group containing at least three carbon atoms and at least one heteroatom selected from the group consisting of N, S, O and P,
k is an integer from 1 to 20, and
l, m, and n are each independently an integer including 0 and at least one of l, m, or n is greater than 0; 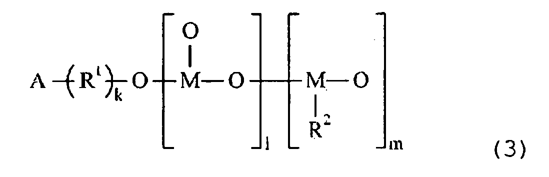 wherein A is N, NH, S, COO⁻, PO₃H⁻ or PO₃²⁻,
R¹ is an alkylene group containing at least one carbon atom, an alkenyl group containing at least two carbon atoms, or a cyclic group containing at least three carbon atoms,
M is Ti, Zn, Si, Sn, W, Ta, Zr, Hf, Al, Y, Fe, Ce or Cr,
R² is an alkyl group containing at least one carbon atom, an alkenyl group containing at least two carbon atoms, or a heterocyclic group containing at least three carbon atoms and at least one heteroatom selected from the group consisting of N, S, O and P,
k is an integer from 1 to 20, and
l and m are each independently an integer including 0 and at least one of l or m is greater than 0; and 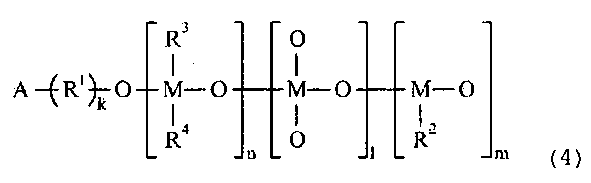 wherein A is N, NH, S, COO⁻, PO₃H⁻ or PO₃²⁻,
R¹ is an alkylene group containing at least one carbon atom, an alkenyl group containing at least two carbon atoms, or a cyclic group containing at least three carbon atoms,
M is Ti, Zn, Si, Sn, W, Ta, Zr, Hf, Al, Y, Fe, Ce or Cr,
R², R³ and R⁴ are each independently an alkyl group containing at least one carbon atom, an alkenyl group containing at least two carbon atoms, or a heterocyclic group containing at least three carbon atoms and at least one heteroatom selected from the group consisting of N, S, O and P,
k is an integer from 1 to 20, and
l, m, and n are each independently an integer including 0 and at least one of l, m, or n is greater than 0.

The nanocrystals may be metal nanocrystals or semiconductor nanocrystals selected from the group consisting of Group II-VI compounds, Group III-V compounds, Group IV-VI compounds, Group IV compounds, and mixtures thereof.

Specifically, the Group II-VI compounds are selected from the group consisting of, but not limited to: binary compounds, such as CdS, CdSe, CdTe, ZnS, ZnSe, ZnTe, ZnO, HgS, HgSe and HgTe; ternary compounds, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS and HgZnSe; and quaternary compounds, such as CdZnSeS, CdZnSeTe, CdZnSTe, CdHgSeS, CdHgSeTe, CdHgSTe, HgZnSeS, HgZnSeTe and HgZnSTe, the Group III-V compounds are selected from the group consisting of, but not limited to: binary compounds, such as GaN, GaP, GaAs, GaSb, AlN, AlP, AlAs, AlSb, InN, InP, InAs and InSb; ternary compounds, such as GaNP, GaNAs, GaNSb, GaPAs, GaPSb, AlNP, AlNAs, AlNSb, AlPAs, AlPSb, InNP, InNAs, InNSb, InPAs, InPSb, GaAlNP, AlGaN, AlGaP, AlGaAs, AlGaSb, InGaN, InGaP, InGaAs, InGaSb, AlInN, AlInP, AlInAs and AlInSb; and quaternary compounds, such as GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs and InAlPSb, the Group IV-VI compounds are selected from the group consisting of, but not limited to: binary compounds, such as SnS, SnSe, SnTe, PbS, PbSe and PbTe; ternary compounds, such as SnSeS, SnSeTe, SnSTe, PbSeS, PbSeTe, PbSTe, SnPbS, SnPbSe and SnPbTe; and quaternary compounds, such as SnPbSSe, SnPbSeTe and SnPbSTe, and the Group IV compounds are selected from the group consisting of, but not limited to:elements such as Si and Ge; and binary compounds, such as SiC and SiGe.

The semiconductor nanocrystals may further include an overcoating to form a core-shell structure. The overcoating may be formed of a material selected from the group consisting of Group II-VI compounds, Group III-V compounds, Group IV-VI compounds, Group IV compounds, and mixtures thereof.

Specifically, the Group II-VI compounds can be selected from the group consisting of, but not limited to, binary compounds, such as CdS, CdSe, CdTe, ZnS, ZnSe, ZnTe, ZnO, HgS, HgSe and HgTe, ternary compounds, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS and HgZnSe, and quaternary compounds, such as CdZnSeS, CdZnSeTe, CdZnSTe, CdHgSeS, CdHgSeTe, CdHgSTe, HgZnSeS, HgZnSeTe and HgZnSTe.

The Group III-V compounds can be selected from the group consisting of, but not limited to, binary compounds, such as GaN, GaP, GaAs, GaSb, AlN, AlP, AlAs, AlSb, InN, InP, InAs and InSb, ternary compounds, such as GaNP, GaNAs, GaNSb, GaPAs, GaPSb, AlNP, AlNAs, AlNSb, AlPAs, AlPSb, InNP, InNAs, InNSb, InPAs, InPSb, GaAlNP, AlGaN, AlGaP, AlGaAs, AlGaSb, InGaN, InGaP, InGaAs, InGaSb, AlInN, AlInP, AlInAs and AlInSb, and quaternary compounds, such as GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs and InAlPSb.

The Group IV-VI compounds can be selected from the group consisting of, but not limited to, binary compounds, such as SnS, SnSe, SnTe, PbS, PbSe and PbTe, ternary compounds, such as SnSeS, SnSeTe, SnSTe, PbSeS, PbSeTe, PbSTe, SnPbS, SnPbSe and SnPbTe, and quaternary compounds, such as SnPbSSe, SnPbSeTe and SnPbSTe; and the Group IV compounds can be selected from the group consisting of, but not limited to, elements such as Si and Ge, and binary compounds, e.g., SiC and SiGe.

The elasticity of the organic groups provides improved processability and mechanical stability to the nanocrystal-metal oxide composites. The metal-carbon bonds formed within the nanocrystal-metal oxide composites are relatively stable against heat and photons. Therefore, the nanocrystal-metal oxide composites exhibit excellent stability to heat and light.

In accordance with another embodiment, there is provided a method for preparing nanocrystal-metal oxide composites.

Specifically, the method comprises modifying the surface of nanocrystals with a surfactant and mixing the surface-modified nanocrystals with a metal oxide precursor having organic groups, a solvent and water to form a sol-gel wherein the surfactant is reactive with the metal oxide precursor.

A known metal oxide precursor may be further added during mixing in the second step. That is, the surface-modified nanocrystals may be mixed with two kinds of metal oxide precursors in the second step.

The nanocrystals used in the first step of the method may be those surrounded by a hydrophobic surfactant. Preferably, the hydrophobic surfactant may possess a group that is reactive with the metal oxide precursor.

The metal oxide precursor having organic groups used in the method can be selected from the group consisting of organosiloxane compounds, organosilane compounds, silsesquioxane compounds, and metal oxides having organic groups. Examples of the metal oxides include titanium, aluminum, vanadium, zinc, tin, tantalum, cerium and chromium oxides.

The organosiloxane compounds may be selected from the group consisting of bis(triethoxysilyl)ethane, bis(triethoxysilyl)butane, bis(triethoxysilyl)octane, bis(trimethoxysilyl)ethane, bis(trimethoxysilyl)butane, bis(trimethoxysilyl)octane, bis(triethoxysilyl)ethylene, bis(trimethoxysilyl)ethylene, bis(triethoxysilyl)acetylene, bis(trimethoxysilyl)acetylene, 1,3,5-tris(diethoxysila)cyclohexane, and 1,3,5-tris(triethoxysilyl)benzene.

The organosilane compounds may be selected from the group consisting of methyltrimethoxysilane, dimethyldimethoxysilane, propyltrimethoxysilane, propyltriethoxysilane, dipropyldimethoxysilane, octyltrimethoxysilane, octyltriethoxysilane, dioctyldimethoxysilane, and hexadecyltriethoxysilane.

The silsesquioxane compound may be 2,4,6,8-tetramethyl-2,4,6,8-tetra(trimethoxysilylethoxy)cyclotetrasiloxane.

The nanocrystals may be metal nanocrystals or semiconductor nanocrystals selected from the group consisting of Group II-VI compounds, Group III-V compounds, Group IV-VI compounds, Group IV compounds, and mixtures thereof.

Specifically, the Group II-VI compounds are selected from the group consisting of, but not limited to: binary compounds, such as CdS, CdSe, CdTe, ZnS, ZnSe, ZnTe, ZnO, HgS, HgSe and HgTe; ternary compounds, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS and HgZnSe; and quaternary compounds, such as CdZnSeS, CdZnSeTe, CdZnSTe, CdHgSeS, CdHgSeTe, CdHgSTe, HgZnSeS, HgZnSeTe and HgZnSTe, the Group III-V compounds are selected from the group consisting of, but not limited to: binary compounds, such as GaN, GaP, GaAs, GaSb, AlN, AlP, AlAs, AlSb, InN, InP, InAs and InSb; ternary compounds, such as GaNP, GaNAs, GaNSb, GaPAs, GaPSb, AlNP, AlNAs, AlNSb, AlPAs, AlPSb, InNP, InNAs, InNSb, InPAs, InPSb, GaAlNP, AlGaN, AlGaP, AlGaAs, AlGaSb, InGaN, InGaP, InGaAs, InGaSb, AlInN, AlInP, AlInAs and AlInSb; and quaternary compounds, such as GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs and InAlPSb, the Group IV-VI compounds are selected from the group consisting of, but not necessarily limited to: binary compounds, such as SnS, SnSe, SnTe, PbS, PbSe and PbTe; ternary compounds, such as SnSeS, SnSeTe, SnSTe, PbSeS, PbSeTe, PbSTe, SnPbS, SnPbSe and SnPbTe; and quaternary compounds, such as SnPbSSe, SnPbSeTe and SnPbSTe, and the Group IV compounds are selected from the group consisting of, but not necessarily limited to:elements such as Si and Ge; and binary compounds, such as SiC and SiGe.

The semiconductor nanocrystals may further include an overcoating to form a core-shell structure. The overcoating may be formed of a material selected from the group consisting of Group II-VI compounds, Group III-V compounds, Group IV-VI compounds, Group IV compounds, and mixtures thereof.

Specifically, the Group II-VI compounds can be selected from the group consisting of, but not limited to, binary compounds, e.g., CdS, CdSe, CdTe, ZnS, ZnSe, ZnTe, ZnO, HgS, HgSe and HgTe, ternary compounds, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS and HgZnSe, and quaternary compounds, such as CdZnSeS, CdZnSeTe, CdZnSTe, CdHgSeS, CdHgSeTe, CdHgSTe, HgZnSeS, HgZnSeTe and HgZnSTe.

The Group III-V compounds can be selected from the group consisting of, but are not limited to, binary compounds, such as GaN, GaP, GaAs, GaSb, AlN, AlP, AlAs, AlSb, InN, InP, InAs and InSb, ternary compounds, such as GaNP, GaNAs, GaNSb, GaPAs, GaPSb, AlNP, AlNAs, AlNSb, AlPAs, AlPSb, InNP, InNAs, InNSb, InPAs, InPSb, GaAlNP, AlGaN, AlGaP, AlGaAs, AlGaSb, InGaN, InGaP, InGaAs, InGaSb, AlInN, AlInP, AlInAs and AlInSb, and quaternary compounds, such as GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs and InAlPSb.

The Group IV-VI compounds can be selected from the group consisting of, but are not limited to, binary compounds, such as SnS, SnSe, SnTe, PbS, PbSe and PbTe, ternary compounds, such as SnSeS, SnSeTe, SnSTe, PbSeS, PbSeTe, PbSTe, SnPbS, SnPbSe and SnPbTe, and quaternary compounds, such as SnPbSSe, SnPbSeTe and SnPbSTe; and the Group IV compounds can be selected from the group consisting of, but are not limited to, elements such as Si and Ge, and binary compounds, such as SiC and SiGe.

The solvent used in the second step may be a polar solvent selected from the group consisting of alkanols having up to 20 carbon atoms, including methanol, ethanol and propanol, acetone, ethyl acetate, dichloromethane, chloroform, dimethylformamide ("DMF"), tetrahydrofuran ("THF"), dimethylsulfoxide ("DMSO"), pyridine, and alkylamines having up to 20 carbon atoms.

The addition of a catalyst and water to the mixture of the surface-modified nanocrystals and the metal oxide precursor induces crosslinking between the nanocrystals and the metal oxide precursor to form alcohol, water, halogen, and other byproducts, which cause a considerable shrinkage in the volume of the final composites. This volume shrinkage can induce mechanical stress in the composites, which can lead to many different kinds of defects such as cracks and pores within the composites.

The nanocrystal-metal oxide composites having organic groups, and in particular the R¹ groups included in the metal oxide precursor, impart elasticity to the composite to achieve improved processability and mechanical stability.

In addition, another advantage associated with the use of the metal oxide precursor having organic groups is that the affinity of the metal oxide precursor for the nanocrystals is improved, making the nanocrystals more readily dispersible. The nanocrystal-metal oxide composites may subsequently be easily molded and cured to form a nanocrystal-metal oxide monolith.

The nanocrystal-metal oxide composites may be coated on the light-emitting surface of a light-emitting diode chip of a light-emitting device (*e.g.,* a light-emitting diode ("LED")). The nanocrystal-metal oxide composites may be directly coated on a device (*e.g.,* a sensor or a solar cell) that uses nanocrystals.

The nanocrystal-metal oxide monolith may be mounted on the light-emitting surface of a light-emitting diode chip.

The nanocrystal-metal oxide monolith may be a monolayer or have a multilayer structure having two or more layers.

A better understanding of exemplary embodiments will be described in more detail with reference to the following examples. It will be noted that these examples are provided only for the purpose of illustration and are not to be construed as limiting the scope of the embodiments thereto.

### EXAMPLES

### Preparative Example 1: Preparation of CdSe//ZnS/CdSZnS Nanocrystals

16g of trioctylamine ("TOA"), 0.3g of octadecylphosphonic acid and 0.4 mmol of cadmium oxide were simultaneously put into a 125-ml flask equipped with a reflux condenser. The mixture was allowed to react with stirring while maintaining the reaction temperature at 300°C to obtain a reaction mixture.

Separately, selenium (Se) powder was dissolved in trioctylphosphine ("TOP") to obtain a Se-TOP complex solution (Se concentration: ca. 2 M). 2 ml of the Se-TOP complex solution was rapidly fed to the reaction mixture and the reaction was allowed to proceed for about 2 minutes.

After the reaction was finished, the reaction mixture was cooled to room temperature as rapidly as possible. Ethanol as a non-solvent was added to the reaction mixture in an amount sufficient to precipitate the reaction product, followed by centrifugation. The precipitate was separated from the supernatant and dispersed in 4ml toluene to prepare a dispersion of CdSe nanocrystals emitting light at 485 nm.

Next, 8g of TOA, 0.1g of oleic acid and 0.4 mmol of zinc acetate were simultaneously put into a 125-mL flask equipped with a reflux condenser. The mixture was allowed to react with stirring while maintaining the reaction temperature at 300°C to obtain a reaction mixture. The CdSe nanocrystal solution was added to the reaction mixture, and then 2 ml of 0.4M S-TOP complex solution was slowly added thereto. The resulting mixture was allowed to react for about one hour to grow ZnS nanocrystals on the surface of the CdSe nanocrystals and interdiffuse a portion of the ZnS nanocrystals into the CdSe nanocrystal along the interface between the CdSe and ZnS nanocrystals to form an alloy interlayer at the interface. As a result, CdSe/ZnS nanocrystals having the alloy interlayer formed at the interface between the CdSe and ZnS nanocrystals (hereinafter, referred to as 'CdSe//ZnS nanocrystals') were prepared.

After completion of the reaction, the reaction mixture was cooled to room temperature as rapidly as possible. Ethanol as a non-solvent was added in an amount sufficient to precipitate the reaction product from the reaction mixture, followed by centrifugation. The precipitate was separated from the supernatant and dispersed in 2ml toluene to prepare a dispersion of the CdSe//ZnS nanocrystals. The CdSe//ZnS nanocrystals had a size of 5 nm and emitted light at 458 nm.

8g of TOA, 0.1g of oleic acid, 0.05 mmol of cadmium oxide and 0.4 mmol of zinc acetate were simultaneously put into a 125-mL flask equipped with a reflux condenser. The mixture was allowed to react with stirring while maintaining the reaction temperature at 300°C to obtain a reaction mixture. The solution of the CdSe//ZnS nanocrystals was added to the reaction mixture, and then 2 ml of an 0.4M S-TOP complex solution was slowly added thereto. The resulting mixture was allowed to react for about one hour to grow CdSZnS nanocrystals on the surface of the CdSe//ZnS nanocrystals. As a result, CdSe//ZnS/CdSZnS nanocrystals emitting light at 535 nm were prepared.

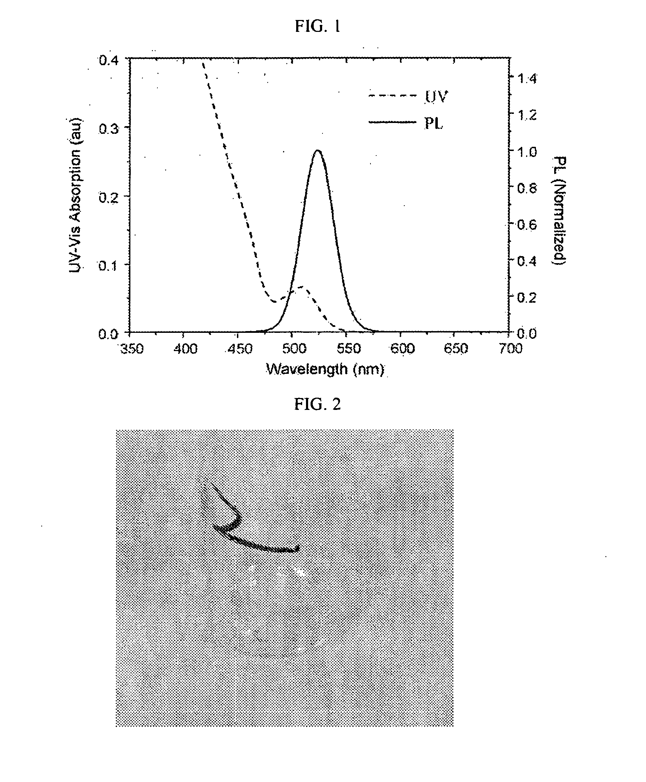

After completion of the reaction, the reaction mixture was cooled to room temperature as rapidly as possible. Ethanol as a non-solvent was added in an amount sufficient to precipitate the reaction mixture, followed by centrifugation. The precipitate was separated from the supernatant and dispersed in 2 ml toluene to prepare a dispersion of the CdSe//ZnS/CdSZnS nanocrystals. The nanocrystals were found to have a quantum efficiency of 93%. The absorption and luminescence spectra of the nanocrystals are shown in FIG. 1.

### Example 1: Preparation of Nanocrystals-silica Composites Containing Organosiloxane

Ethanol was added in an amount sufficient to induce precipitation in 1 mL of the toluene solution of the green emitting CdSe//ZnS/CdSZnS (nanocrystal concentration 1 wt%) prepared in Preparative Example 1, followed by centrifugation to obtain a precipitate. The precipitate was collected. Pyridine 1 ml was added to the precipitate and stirred until the solution became transparent.

Hexane was added to the pyridine solution of the nanocrystals in an amount sufficient to obtain a precipitate. The precipitate was collected, dissolved in a 10 vol% pyridine solution of 1:1 mole ratio of 6-mercaptohexanol and propylamine, and stirred for about 2 hours.

The addition of a sufficient amount of hexane to the solution gave a precipitate. 100 µl of tetraethoxyorthosilane ("TEOS"), 100 µl of 1,3,5-tris(diethoxysila)cyclohexane, 100 µl of ethanol, 100 µl of propylamine and 50 µl of water were added to the precipitate, stirred, put into a vial, and dried at room temperature to prepare CdSe//ZnS/CdSZnS nanocrystals-silica composites.

The composites were cured. FIG. 2 shows the shape of the cured composites. FIG. 2 demonstrates that the shape of the cured composites was well maintained.

### Example 2: Preparation of Nanocrystals-silica Composites Containing Organosiloxane

Ethanol was added in an amount sufficient to induce precipitation in 1 ml of the toluene solution of the green emitting CdSe//ZnS/CdSZnS (nanocrystal concentration 1 wt%) prepared in Preparative Example 1, followed by centrifugation to obtain a precipitate. The precipitate was collected. Pyridine 1ml was added to the precipitate and stirred until the solution became transparent.

Hexane was added to the pyridine solution of the nanocrystals in an amount sufficient to obtain a precipitate. The precipitate was collected, dissolved in a 10 vol% pyridine solution of 1:1 mole ratio of 6-mercaptohexanol and propylamine, and stirred for about 2 hours.

The addition of hexane to the solution gave a precipitate. 100 µl of tetraethoxyorthosilane ("TEOS"), 100 µl of bis(triethoxysilyl)octane, 100 µl of ethanol, 100 µl of propylamine and 50 µl of water were added to the precipitate, stirred, put into a vial, and dried at room temperature to prepare CdSe//ZnS/CdSZnS nanocrystals-silica composite.

### Comparative Example 1: Preparation of Nanocrystals-silica Composites

Ethanol was added to 1 mL of the toluene solution of the green emitting CdSe//ZnS/CdSZnS (nanocrystal concentration 1 wt%) prepared in Preparative Example 1, followed by centrifugation to obtain a precipitate. The precipitate was collected. Pyridine 1 ml was added to the precipitate and stirred until the solution became transparent.

Hexane was added to the pyridine solution of the nanocrystals in an amount sufficient to obtain a precipitate. The precipitate was collected, dissolved in a 10 vol% pyridine solution of 1:1 mole ratio of 6-mercaptohexanol and propylamine , and stirred for about 2 hours.

The addition of hexane to the solution in a sufficient amount gave a precipitate. 200 µl of tetraethoxyorthosilane (TEOS), 100 µl of ethanol, 100 µl of propylamine and 50 µl of water were added to the precipitate, stirred, put into a vial, and dried at room temperature to prepare CdSe//ZnS/CdSZnS nanocrystals-silica composite.

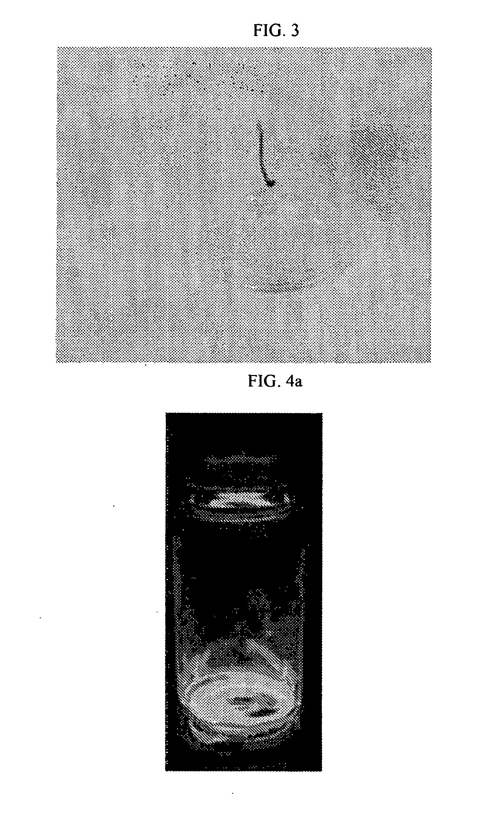

Cracks were formed in the composites of the Comparative Example 1 during curing. FIG. 3 shows the shape of the cured composites of Comparative Example 1, and demonstrates that the composites lost their shape due to the formation of cracks during curing, unlike the composites prepared in Example 1.

### Experimental Example 1

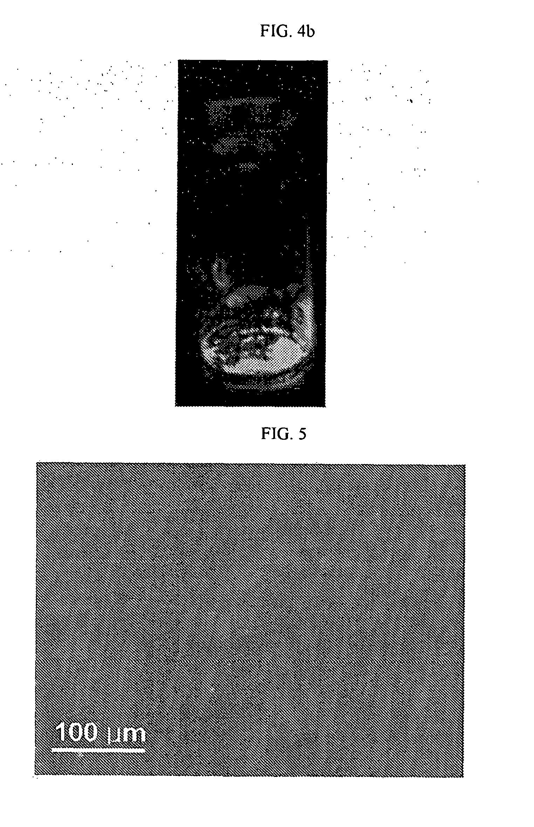

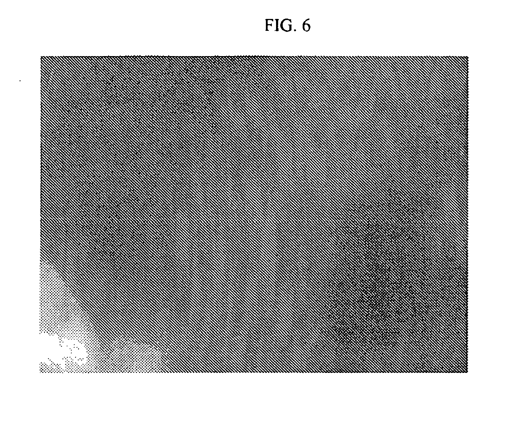

The composites and the monolith prepared in each of Example 2 and Comparative Example 1 were cured and observed for light emission under a 365 nm-UV lamp (FIGs. 4a and 4b). Optical microscopy images of the cured composites and monolith are shown in FIGs. 5 and 6, respectively. FIGs. 4a and 4b demonstrate that shrinkage in the volume of the cured composites of Example 2 was much lower due to the presence of the long alkyl chains (as obtained from the bis(triethoxysilyl)octane used in the formation of the nanocrystal silica composite of Example 2)) than that of the cured monolith of Comparative Example 1. The images of FIGs. 5 and 6 show that no cracks were observed in the cured composites of Example 2 whereas cracks were observed in the cured monolith of Comparative Example 1.

While the present invention has been described in detail with reference to its preferred embodiments, the embodiments are simply for the purpose of illustration. It will be understood by those skilled in the art that various modifications and their equivalents can be made in the present invention without departing from the scope of the invention. Thus, the genuine scope of the technical protection of the present invention should be defined by the claims that follow.

## Claims

1. A nanocrystal-metal oxide composite comprising a nanocrystal and a metal oxide bound to the nanocrystal wherein the metal oxide is a compound represented by Formula 1: 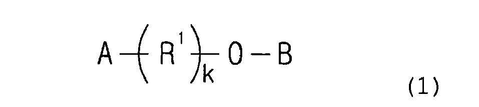 wherein A is N, NH, S, COO⁻, PO₃H⁻ or PO₃²⁻,
R¹ is an alkylene group containing at least one carbon atom, an alkenyl group containing at least two carbon atoms, or a cyclic group containing at least three carbon atoms,
B is one or more repeating units selected from the group
consisting of 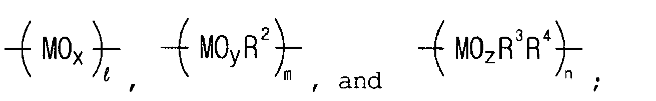 wherein each M is Ti, Zn, Si, Sn, W, Ta, Zr, Hf, Al, Y, Fe, Ce or Cr,
R², R³ and R⁴ are each independently an alkyl group containing at least one carbon atom, an alkenyl group containing at least two carbon atoms, or a heterocyclic group containing at least three carbon atoms and at least one heteroatom selected from the group consisting of N, S, O and P,
k is an integer from 1 to 20,
1, m, and n are each independently an integer including 0 and at least one of 1, m, or n is greater than 0, and
x, y, and z are each independently an integer from 1 to 3.

2. The composite of claim 1, wherein the nanocrystal is a metal nanocrystal or a semiconductor nanocrystal selected from the group consisting of Group 2-6 compounds, Group 3-5 compounds, Group 4-6 compounds, Group 4 compounds, and mixtures thereof.

3. The composite of claim 2, wherein the Group 2-6 compounds are selected from the group consisting of CdSe, CdTe, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, CdZnSeS, CdZnSeTe, CdZnSTe, CdHgSeS, CdHgSeTe, CdHgSTe, HgZnSeS, HgZnSeTe, and HgZnSTe; the Group III-V compounds are selected from the group consisting of GaN, GaP, GaAs, GaSb, AlN, AlP, AlAs, AlSb, InN, InP, InAs, InSb, GaNP, GaNAs, GaNSb, GaPAs, GaPSb, AlNP, AlNAs, AlNSb, AlPAs, AlPSb, InNP, InNAs, InNSb, InPAs, InPSb, GaAlNP, GaAlNAs, GaAlNSb, GaAlPAs, GaAlPSb, GalnNP, GalnNAs, GalnNSb, GalnPAs, GalnPSb, InAlNP, InAlNAs, InAlNSb, InAlPAs, and InAlPSb; the Group IV-VI compounds are selected from the group consisting of SnS, SnSe, SnTe, PbS, PbSe, PbTe, SnSeS, SnSeTe, SnSTe, PbSeS, PbSeTe, PbSTe, SnPbS, SnPbSe, SnPbTe, SnPbSSe, SnPbSeTe, and SnPbSTe; and the Group IV compounds are selected from the group consisting of Si, Ge, SiC, and SiGe.

4. A light-emitting diode device comprising nanocrystal-metal oxide composites according to any of claims 1 to 3.

5. A method for preparing nanocrystal-metal oxide composites, the method comprising modifying the surface of nanocrystals with a surfactant and mixing the surface-modified nanocrystals with a metal oxide precursor having organic groups, a solvent and water to form a sol-gel wherein the surfactant is reactive with the metal oxide precursor, and wherein the metal oxide is a compound represented by Formula 1: 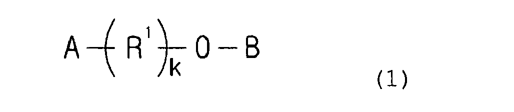 wherein A is N, NH, S, COO⁻, PO₃H⁻ or PO₃^{2-,}
R¹ is an alkylene group containing at least one carbon atom, an alkenyl group containing at least two carbon atoms, or a cyclic group containing at least three carbon atoms,
B is one or more repeating units selected from the group
consisting of 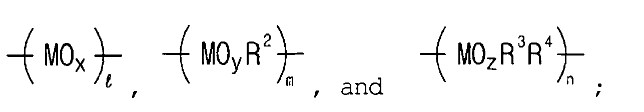 wherein each M is Ti, Zn, Si, Sn, W, Ta, Zr, Hf, Al, Y, Fe, Ce or Cr,
R ² R³ and R⁴ are each independently an alkyl group containing at least one carbon atom, an alkenyl group containing at least two carbon atoms, or a heterocyclic group containing at least three carbon atoms and at least one heteroatom selected from the group consisting of N, S, O and P,
k is an integer from 1 to 20,
1, m, and n are each independently an integer including 0 and at least one of 1, m, or n is greater than 0, and
x, y, and z are each independently an integer from 1 to 3.

6. The method of claim 5, wherein the nanocrystals used in the first step are those surrounded by a hydrophobic surfactant.

7. The method of claim 5 or 6, wherein an additional metal oxide precursor is added during mixing.

8. The method of any of claims 5-7, wherein the solvent used in the second step is a polar solvent selected from the group consisting of alkanols, acetone, ethyl acetate, dichloromethane, chloroform, DMF, THF, DMSO, pyridine, and alkylamines.

9. The method of any of claims 5-8, wherein the metal oxide precursor having organic groups is selected from the group consisting of organosiloxane compounds, organosilane compounds, silsesquioxane compounds, titanium oxides, aluminum oxides, vanadium oxides, zinc oxides, tin oxides, tantalum oxides, cerium oxides and chromium oxides, having organic groups.

10. The method of claim 9, wherein the organosiloxane compounds are selected from the group consisting of bis(triethoxysilyl)ethane, bis(triethoxysilyl)butane, bis(triethoxysilyl)octane, bis(trimethoxysilyl)ethane, bis(trimethoxysilyl)butane, bis(trimethoxysilyl)octane, bis(triethoxysilyl)ethylene, bis(trimethoxysilyl)ethylene, bis(triethoxysilyl)acetylene, bis(trimethoxysilyl)acetylene, 1,3,5-tris(diethoxysila)cyclohexane, and 1,3,5-tris(triethoxysilyl)benzene.

11. The method of claim 9, wherein the organosilane compounds are selected from the group consisting of methyltrimethoxysilane, dimethyldimethoxysilane, propyltrimethoxysilane, propyltriethoxysilane, dipropyldimethoxysilane, octyltrimethoxysilane, octyltriethoxysilane, dioctyldimethoxysilane, and hexadecyltriethoxysilane.

12. The method of claim 9, wherein the silsesquioxane compound is 2, 4, 6, 8-tetramethyl-2, 4, 6, 8-tetra(trimethoxysilylethoxy)cyclotetrasiloxane.

13. The method of any of claims 5-12, wherein the nanocrystals are metal nanocrystals or semiconductor nanocrystals selected from the group consisting of Group 2-6 compounds, Group 3-5 compounds, Group 4-6 compounds, Group 4 compounds, and mixtures thereof.

14. A method for forming a nanocrystal-metal oxide monolith by solidifying the composites in a sol-gel form prepared by the method of any of claims 5-13.

## Patentansprüche

1. Nanokristall-Metalloxid-Verbundwerkstoff, der einen Nanokristall und ein an den Nanokristall gebundenes Metalloxid umfasst, wobei das Metalloxid eine durch die Formel 1 dargestellte Verbindung ist: 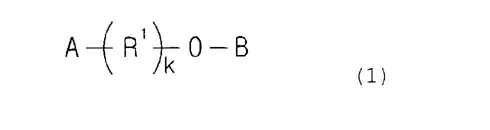 wobei A N, NH, S, COO⁻, PO₃H⁻ oder PO₃²⁻ ist,
R¹ eine Alkylengruppe mit mindestens einem Kohlenstoffatom, eine Alkenylgruppe mit mindestens zwei Kohlenstoffatomen oder eine cyclische Gruppe mit mindestens drei Kohlenstoffatomen ist,
B eine oder mehrere sich wiederholende Einheit(en) ist, ausgewählt aus der Gruppe
bestehend aus 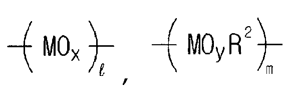 und 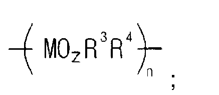 wobei jedes M Ti, Zn, Si, Sn, W, Ta, Zr, Hf, Al, Y, Fe, Ce oder Cr ist, R², R³ und R⁴ jeweils unabhängig eine Alkylgruppe mit mindestens einem Kohlenstoffatom, eine Alkenylgruppe mit mindestens zwei Kohlenstoffatomen oder eine heterocyclische Gruppe mit mindestens drei Kohlenstoffatomen und mindestens einem Heteroatom, ausgewählt aus der Gruppe bestehend aus N, S, O und P, ist,
k eine ganze Zahl von1 bis 20 ist,
l, m und n jeweils unabhängig eine ganze Zahl einschließlich 0 ist und mindestens eines von l, m oder n größer als 0 ist und
x, y und z jeweils unabhängig eine ganze Zahl von 1 bis 3 ist.

2. Verbundwerkstoff nach Anspruch 1, wobei der Nanokristall ein Metall-Nanokristall oder ein Halbleiter-Nanokristall ist, ausgewählt aus der Gruppe bestehend aus Verbindungen der Gruppe 2-6, Verbindungen der Gruppe 3-5, Verbindungen der Gruppe 4-6, Verbindungen der Gruppe 4 und Gemischen derselben.

3. Verbundwerkstoff nach Anspruch 2, wobei die Verbindungen der Gruppe 2-6 ausgewählt sind aus der Gruppe bestehend aus CdSe, CdTe, ZnS, ZnSe, ZnTe, ZnO, HgS,
HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, CdZnSeS, CdZnSeTe, CdZnSTe, CdHgSeS, CdHgSeTe, CdHgSTe, HgZnSeS, HgZnSeTe und HgZnSTe; die Verbindungen der Gruppe III-V ausgewählt sind aus der Gruppe bestehend aus GaN, GaP, GaAs, GaSb, AIN, AlP, AlAs, AlSb, InN, InP, InAs, InSb, GaNP, GaNAs, GaNSb, GaPAs, GaPSb, AINP, AINAs, AINSb, AIPAs, AIPSb, InNP, InNAs, InNSb, InPAs, InPSb, GaAlNP, GaAlNAs, GaAINSb, GaAlPAs, GaAIPSb, GalnNP, GalnNAs, GalnNSb, GalnPAs, GalnPSb, InAlNP, InAlNAs, InAlNSb, InAlPAs und InAlPSb; die Verbindungen der Gruppe IV-VI ausgewählt sind aus der Gruppe bestehend aus SnS, SnSe, SnTe, PbS, PbSe, PbTe, SnSeS, SnSeTe, SnSTe, PbSeS, PbSeTe, PbSTe, SnPbS, SnPbSe, SnPbTe, SnPbSSe, SnPbSeTe und SnPbSTe; und die Verbindungen der Gruppe IV ausgewählt sind aus der Gruppe bestehend aus Si, Ge, SiC und SiGe.

4. Leuchtdiodenvorrichtung, die Nanokristall-Metalloxid-Verbundwerkstoffe nach einem der Ansprüche 1 bis 3 umfasst.

5. Verfahren zur Herstellung von Nanokristall-Metalloxid-Verbundwerkstoffen, wobei das Verfahren umfasst: Modifizieren der Oberfläche von Nanokristallen mit einem grenzflächenaktiven Stoff und Mischen des oberflächenmodifizierten Nanokristalls mit einem Metalloxidvorläufer mit organischen Gruppen, einem Lösungsmittel und Wasser zwecks Ausbildung eines Sol-Gels, wobei der grenzflächenaktive Stoff zur Reaktion mit dem Metalloxidvorläufer fähig ist und wobei das Metalloxid eine durch die Formel 1 dargestellte Verbindung ist: 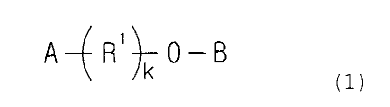 wobei A N, NH, S, COO⁻, PO₃H⁻ oder PO₃²⁻ ist,
R¹ eine Alkylengruppe mit mindestens einem Kohlenstoffatom, eine Alkenylgruppe mit mindestens zwei Kohlenstoffatomen oder eine cyclische Gruppe mit mindestens drei Kohlenstoffatomen ist,
B eine oder mehrere sich wiederholende Einheit(en) ist, ausgewählt aus der Gruppe
bestehend aus 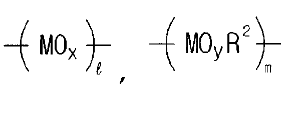 und 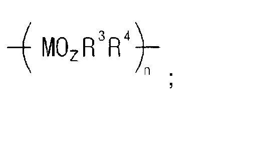 wobei jedes M Ti, Zn, Si, Sn, W, Ta, Zr, Hf, Al, Y, Fe, Ce oder Cr ist, R², R³ und R⁴ jeweils unabhängig eine Alkylgruppe mit mindestens einem Kohlenstoffatom, eine Alkenylgruppe mit mindestens zwei Kohlenstoffatomen oder eine heterocyclische Gruppe mit mindestens drei Kohlenstoffatomen und mindestens einem Heteroatom, ausgewählt aus der Gruppe bestehend aus N, S, O und P, ist,
k eine ganze Zahl von1 bis 20 ist,
l, m und n jeweils unabhängig eine ganze Zahl einschließlich 0 ist und mindestens eines von l, m oder n größer als 0 ist und
x, y und z jeweils unabhängig eine ganze Zahl von 1 bis 3 ist.

6. Verfahren nach Anspruch 5, wobei die im ersten Schritt verwendeten Nanokristalle die von einem hydrophoben grenzflächenaktiven Stoff umgebenen sind.

7. Verfahren nach Anspruch 5 oder 6, wobei während des Mischens ein zusätzlicher Metalloxidvorläufer zugegeben wird.

8. Verfahren nach einem der Ansprüche 5-7, wobei das im zweiten Schritt verwendete Lösungsmittel ein polares Lösungsmittel ist, ausgewählt aus der Gruppe bestehend aus Alkanolen, Aceton, Ethylacetat, Dichlormethan, Chloroform, DMF, THF, DMSO, Pyridin und Alkylaminen.

9. Verfahren nach einem der Ansprüche 5-8, wobei der Metalloxidvorläufer mit organischen Gruppen ausgewählt ist aus der Gruppe bestehend aus Organosiloxanverbindungen, Organosilanverbindungen, Silsesquioxanverbindungen, Titanoxiden, Aluminiumoxiden, Vanadiumoxiden, Zinkoxiden, Zinnoxiden, Tantaloxiden, Ceroxiden und Chromoxiden, mit organischen Gruppen.

10. Verfahren nach Anspruch 9, wobei die Organosiloxanverbindungen ausgewählt sind aus der Gruppe bestehend aus Bis(triethoxysilyl)ethan, Bis(triethoxysilyl)butan, Bis(triethoxysilyl)octan, Bis(trimethoxysilyl)ethan, Bis(trimethoxysilyl)butan, Bis(trimethoxysilyl)octan, Bis-(triethoxysilyl)ethylen, Bis(trimethoxysilyl)ethylen, Bis(triethoxysilyl)acetylen, Bis(trimethoxysilyl)acetylen, 1,3,5-Tris(diethoxysila)cyclohexan und 1,3,5-Tris(triethoxysilyl)benzen.

11. Verfahren nach Anspruch 9, wobei die Organosilanverbindungen ausgewählt sind aus der Gruppe bestehend aus Methyltrimethoxysilan, Dimethyldimethoxysilan, Propyltrimethoxysilan, Propyltriethoxysilan, Dipropyldimethoxysilan, Octyltrimethoxysilan, Octyltriethoxysilan, Dioctyldimethoxysilan und Hexadecyltriethoxysilan.

12. Verfahren nach Anspruch 9, wobei die Silsesquioxanverbindung 2,4,6,8-Tetramethyl-2,4,6,8-tetra(trimethoxysilylethoxy)cyclotetrasiloxan ist.

13. Verfahren nach einem der Ansprüche 5-12, wobei die Nanokristalle Metall-Nanokristalle oder Halbleiter-Nanokristalle sind, ausgewählt aus der Gruppe bestehend aus Verbindungen der Gruppe 2-6, Verbindungen der Gruppe 3-5, Verbindungen der Gruppe 4-6, Verbindungen der Gruppe 4 und Gemischen derselben.

14. Verfahren zur Ausbildung eines Nanokristall-Metalloxid-Monolithen durch Verfestigen der durch das Verfahren nach einem der Ansprüche 5-13 hergestellten Verbundwerkstoffe in Sol-Gel-Form.

## Revendications

1. Composite d'oxyde métallique à nanocristaux comprenant un nanocristal et un oxyde métallique lié au nanocristal dans lequel l'oxyde métallique est un composé représenté par la Formule 1 : 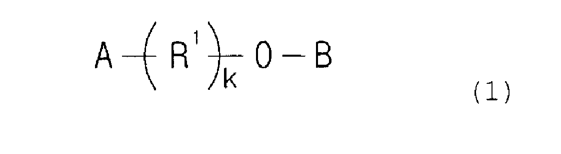 dans lequel A représente N, NH, S, COO⁻, PO₃H⁻ ou PO₃²⁻,
R¹ est un groupe alkylène contenant au moins un atome de carbone, un groupe alcényle contenant au moins deux atomes de carbone ou un groupe cyclique contenant au moins trois atomes de carbone,
B est un ou plusieurs motifs répétés choisis dans le groupe constitué par 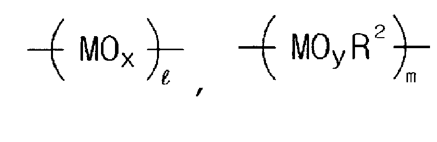 et 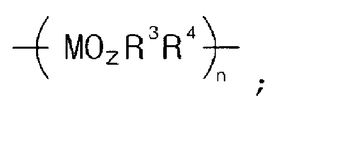 dans lequel chaque M représente Ti, Zn, Si, Sn, W, Ta, Zr, Hf, Al, Y, Fe, Ce ou Cr, R², R³ et R⁴ sont chacun indépendamment les uns des autres un groupe alkyle contenant au moins un atome de carbone, un groupe alcényle contenant au moins deux atomes de carbone ou un groupe hétérocyclique contenant au moins trois atomes de carbone et au moins un hétéroatome choisi dans le groupe constitué par N, S, O et P,
k est un nombre entier compris entre 1 et 20,
l, m et n sont chacun indépendamment les uns des autres un nombre entier, y compris 0, et au moins l'un de l, m ou n est supérieur à 0, et
x, y et z sont chacun indépendamment les uns des autres un nombre entier compris entre 1 et 3.

2. Composite selon la revendication 1, dans lequel le nanocristal est un nanocristal métallique ou un nanocristal semi-conducteur choisi dans le groupe constitué par les composés du groupe 2-6, les composés du groupe 3-5, les composés du groupe 4-6, les composés du groupe 4 et les mélanges de ceux-ci.

3. Composite selon la revendication 2, dans lequel les composés du groupe 2-6 sont choisis dans le groupe constitué par CdSe, CdTe, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, CdZnSeS, CdZnSeTe, CdZnSTe, CdHgSeS, CdHgSeTe, CdHgSTe, HgZnSeS, HgZnSeTe et HgZnSTe; les composés du groupe III-V sont choisis dans le groupe constitué par GaN, GaP, GaAs, GaSb, AIN, AIP, AlAs, AlSb, InN, InP, InAs, InSb, GaNP, GaNAs, GaNSb, GaPAs, GaPSb, AINP, AlNAs, AlNSb, AlPAs, AlPSb, InNP, InNAs, InNSb, InPAs, InPSb, GaAlNP, GaAlNAs, GaAINSb, GaAlPAs, GaAlPSb, GalnNP, GalnNAs, GalnNSb, GalnPAs, GalnPSb, InAlNP, InAlNAs, InAlNSb, InAlPAs et InAlPSb ; les composés du groupe IV-VI sont choisis dans le groupe constitué par SnS, SnSe, SnTe, Pbs, PbSe, PbTe, SnSes, SnSeTe, SnSTe, PbSeS, PbSeTe, PbSTe, SnPbS, SnPbSe, SnPbTe, SnPbSSe, SnPbSeTe et SnPbSTe; et les composés du groupe IV sont choisis dans le groupe constitué par Si, Ge, SiC et SiGe.

4. Dispositif à diodes électroluminescentes comprenant des composites d'oxyde métallique à nanocristaux selon l'une quelconque des revendications 1 à 3.

5. Procédé de préparation de composites d'oxyde métallique à nanocristaux, le procédé comprenant la modification de la surface des nanocristaux avec un agent tensioactif et le mélange des nanocristaux à surface modifiée avec un précurseur d'oxyde métallique ayant des groupes organiques, un solvant et de l'eau pour former un sol-gel dans lequel l'agent tensioactif réagit avec le précurseur d'oxyde métallique, et dans lequel l'oxyde métallique est un composé représenté par la Formule 1 : 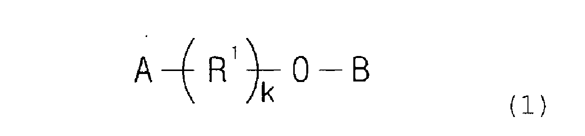 dans lequel A représente N, NH, S, COO⁻, PO₃H⁻ ou PO₃²⁻,
R¹ est un groupe alkylène contenant au moins un atome de carbone, un groupe alcényle contenant au moins deux atomes de carbone ou un groupe cyclique contenant au moins trois atomes de carbone,
B est un ou plusieurs motifs répétés choisis dans le groupe constitué par 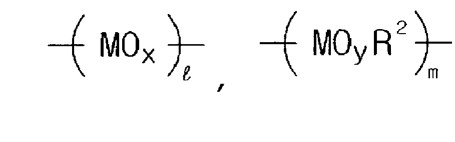 et 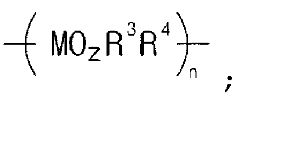 dans lequel chaque M représente Ti, Zn, Si, Sn, W, Ta, Zr, Hf, Al, Y, Fe, Ce ou Cr, R², R³ et R⁴ sont chacun indépendamment les uns des autres un groupe alkyle contenant au moins un atome de carbone, un groupe alcényle contenant au moins deux atomes de carbone ou un groupe hétérocyclique contenant au moins trois atomes de carbone et au moins un hétéroatome choisi dans le groupe constitué par N, S, O et P,
k est un nombre entier compris entre 1 et 20,
l, m et n sont chacun indépendamment les uns des autres un nombre entier, y compris 0, et au moins l'un de l, m ou n est supérieur à 0, et
x, y et z sont chacun indépendamment les uns des autres un nombre entier compris entre 1 et 3.

6. Procédé selon la revendication 5, dans lequel les nanocristaux utilisés dans la première étape sont ceux entourés par un agent tensioactif hydrophobe.

7. Procédé selon la revendication 5 ou 6, dans lequel un précurseur d'oxyde métallique supplémentaire est ajouté pendant le mélange.

8. Procédé selon l'une quelconque des revendications 5 à 7, dans lequel le solvant utilisé dans la deuxième étape est un solvant polaire choisi dans le groupe constitué par les alcanols, l'acétone, l'acétate d'éthyle, le dichlorométhane, le chloroforme, le DMF, le THF, le DMSO, la pyridine et les alkylamines.

9. Procédé selon l'une quelconque des revendications 5 à 8, dans lequel le précurseur d'oxyde métallique ayant des groupes organiques est choisi dans le groupe constitué par les composés organosiloxane, les composés organosilane, les composés silsesquioxane, les oxydes de titane, les oxydes d'aluminium, les oxydes de vanadium, les oxydes de zinc, les oxydes d'étain, les oxydes de tantale, les oxydes de cérium et les oxydes de chrome, ayant des groupes organiques.

10. Procédé selon la revendication 9, dans lequel les composés organosiloxane sont choisis dans le groupe constitué par le bis(triéthoxysilyl)éthane, le bis(triéthoxysilyl)butane, le bis(triéthoxysilyl)octane, le bis(triméthoxysilyl)éthane, le bis(triméthoxysilyl)butane, le bis(triméthoxysilyl)octane, le bis(triéthoxysilyl)éthylène, le bis(triméthoxysilyl)éthylène, le bis(triéthoxysilyl)acétylène, le bis(triméthoxysilyl)acétylène, le 1,3,5-tris(diéthoxysila)cyclohexane et le 1,3,5-tris(diéthoxysilyl)benzène.

11. Procédé selon la revendication 9, dans lequel les composés organosilane sont choisis dans le groupe constitué par le méthyltriméthoxysilane, le diméthyltriméthoxysilane, le propyltriméthoxysilane, le propyltriéthoxysilane, le dipropyldiméthoxysilane, l'octyltriméthoxysilane, l'octyletriéthoxysilane, le dioctyldiméthoxysilane et l'hexadécyltriéthoxysilane.

12. Procédé selon la revendication 9, dans lequel le composé silsesquioxane est le 2,4,6,8-tétraméthyl-2,4,6,8-tétra(triméthoxysilyléthoxy)cyclotétrasiloxane.

13. Procédé selon l'une quelconque des revendications 5 à 12, dans lequel les nanocristaux sont des nanocristaux métalliques ou des nanocristaux semi-conducteurs choisis dans le groupe constitué par les composés du groupe 2-6, les composés du groupe 3-5, les composés du groupe 4-6, les composés du groupe 4 et les mélanges de ceux-ci.

14. Procédé de formation d'un monolithe d'oxyde métallique à nanocristaux par solidification des composites en une forme sol-gel préparée par le procédé selon l'une quelconque des revendications 5 à 13.
